# EUROPEAN PATENT SPECIFICATION

(11) **EP 3 879 928 B1**
(45) Date of publication and mention of the grant of the patent: **31.08.2022**
(21) Application number: 21162033.1
(22) Date of filing: 11.03.2021
(51) Int. Cl.: H05B 6/12

(54) **ELECTRIC RANGE**
ELEKTRISCHE HERDPLATTE
APPAREIL ÉLECTRIQUE

(30) Priority: 12.03.2020 KR 20200030998
(43) Date of publication of application: 15.09.2021
(73) Proprietor: LG Electronics Inc., Seoul 07336 (KR)
(72) Inventor: CHA, Jungmin, Seoul 08592 (KR); PARK, Il Young, Seoul 08592 (KR); KIM, Seunghak, Seoul 08592 (KR); PARK, Myoeng Soo, Seoul 08592 (KR)
(74) Representative: Ter Meer Steinmeister & Partner

(56) References cited:
- WO-A1-2008/155922
- KR-A- 20140 124 106
- KR-A- 20140 131 118
- KR-A- 20160 025 170
- US-A1- 2019 234 616

## Description

### 1. Field of Invention

Disclosed herein is an electric range.

### 2. Description of Related Art

Various types of cooking appliances are used to heat food at homes or restaurants. The cooking appliances include gas ranges using gas and electric ranges using electricity.

The electric ranges are classified as resistance heating-type electric ranges and induction heating-type electric ranges.

In a resistance heating method, electric current is supplied to a metallic resistance wire or a non-metallic heat generation element such as silicon carbide to generate heat, and the generated heat is radiated or conducted to heat an object to be heated (e.g., a cooking vessel such as a pot, a frying pan and the like).

In an induction heating method, high-frequency power is supplied to a coil to generate a magnetic field around the coil, and eddy current produced in the generated magnetic field is used to heat an object to be heated made of a metallic material.

When electric current is supplied to a working coil or a heating coil, heat is generated while an object to be heated is inductively heated. The object to be heated is heated by the generated heat.

An electric range of the related, having the above configuration, includes a main body, a working coil and a cover plate. A substrate is disposed in the main body. A base plate is disposed at an upper end of the main body.

The working coil is disposed at an upper end of the base plate. The working coil has an insulation sheet and a ferrite. The working coil is disposed on the insulation sheet. The ferrite is disposed on the base plate.

The cover plate is disposed on the main body. The cover plate is disposed over/on/in an upper portion of the working coil. An object to be heated is mounted onto the cover plate.

Based on the above configuration, the working coil forms a magnetic field when electric current flows. Based on the induction heating method, the magnetic field allows of heat generation of the cooking vessel (i.e., an object to be heated) itself, mounted onto the cover plate, to heat an object to be cooked accommodated in the cooking vessel.

The substrate controls supply of induced current to the working coil.

The electric range of the related art having the above configuration includes a temperature fuse that is used to control temperature when the electric range overheats. The temperature fuse is disposed on a working coil base constituting the working coil.

A working coil base of the related art has a holder in which a temperature fuse is installed.

A holder, which prevents a temperature fuse from escaping or tilting when an impact occurs in an induction range or an induction range is moved, is disclosed in Korean Patent Publication No. 10-2016-0025170.

The holder of the related art has a structure in which a temperature fuse is inserted into the holder. The holder has an additional escape prevention guide for prevention of an escape of the temperature fuse. When the temperature fuse is inserted and installed in the holder during assembly of an electric range, the insertion of the temperature fuse may be prevented by the escape prevention guide, causing difficulty in assembly.

The temperature fuse of the related art comes into close contact with a lower end of the cover plate made of glass. When an external impact is applied to the cover plate, the impact is directly delivered to the temperature fuse in close contact with the cover plate. Thus, the temperature fuse and the glass-based cover plate can be damaged by the impact.

In the related art, a temperature sensor for measuring temperature of the cover plate is installed in a main body as a component in addition to the temperature fuse. Since the temperature fuse and the temperature sensor are respectively installed, efficient assembly cannot be ensured.

Additionally, when an external impact is applied to the cover plate, the temperature sensor cannot absorb the impact, resulting in an operational error or damage of the temperature sensor. Thus, when the temperature sensor overheats in a state of being broken, the temperature fuse can be blown.

### SUMMARY OF INVENTION

It is an object of the present invention to provide to an electric range in which a temperature fuse and a temperature sensor are installed in a single holder that has elasticity and is disposed at an upper end of an induction heating object, thereby absorbing an external impact and preventing the temperature fuse and the temperature sensor from escaping.

It is another object of the present invention to provide directed to an electric range in which the temperature sensor elastically comes into close contact with a lower surface of a cover plate, thereby preventing damage to the cover plate by an impact.

It is another object of the present invention to provide directed to an electric range in which a sensing surface of an upper end of the temperature sensor comes into close contact with the lower surface of the cover plate, thereby preventing the temperature fuse from begin blown when the temperature sensor overheats due to damage to the temperature sensor.

Aspects are not limited to the above ones, and other aspects and advantages that are not mentioned above can be clearly understood from the following description and can be more clearly understood from the embodiments set forth herein. Additionally, the aspects and advantages of the present disclosure can be realized via means and combinations thereof that are described in the appended claims.

One or more of these objects are solved by the features of the independent claim. An electric range according to the present invention may include an elastic holder for fixing a fuse and a sensor in a central portion of an induction heating object disposed on a base plate, thereby stably fixing the fuse and sensor against an external impact.

An upper end of the sensor according to the disclosure may come into close contact with a lower surface of a cover plate disposed over/on/in an upper portion of an induction heating object, thereby stably measuring temperature of the cover plate and absorbing an external impact.

According to the disclosure, a temperature fuse and a temperature sensor may be installed in a single holder that has elasticity and is disposed at an upper end of an induction heating object, thereby absorbing an external impact and preventing the temperature fuse and the temperature sensor from escaping.

According to the disclosure, the temperature sensor may elastically come into close contact with a lower surface of a cover plate, thereby preventing damage to the cover plate by an impact.

According to the disclosure, a sensing surface of an upper end of the temperature sensor may come into close contact with the lower surface of the cover plate, thereby preventing the temperature fuse from begin blown when the temperature sensor overheats due to damage to the temperature sensor.

According to one aspect an electric range comprises: a case an upper portion of which is open and which has an inner space; a driving circuit disposed in the inner space of the case; a base plate disposed in the upper portion of the case; an induction heating object disposed on/in an upper portion of the base plate; a cover plate disposed on/in an upper portion of the induction heating object; and an elastic holder which is attachably and detachably disposed in the induction heating object, and in which a fuse and a sensor are accommodated at different positions in a single body, wherein the sensor preferably contacts a lower surface of the cover plate.

According to a further aspect, an electric range comprises: a case an upper portion of which is open and which has an inner space; a driving circuit disposed in the inner space of the case; a base plate disposed in the upper portion of the case; an induction heating object disposed on/in an upper portion of the base plate; a cover plate disposed on/in an upper portion of the induction heating object; and an elastic holder which is disposed in the induction heating object, and in which a fuse and a sensor are accommodated at different positions.

According to another aspect, an electric range comprises: a case having an inner space; a driving circuit disposed in the inner space of the case; a base plate disposed in the case on the driving circuit; an induction heating object disposed on the base plate; a cover plate disposed on the induction heating object; and an elastic holder disposed in an insertion hole within the induction heating object and accommodating a fuse and a sensor. The sensor may be in contact with the cover plate.

The electric range according to any one of these aspects may include one or more of the following features:

The sensor may be in contact with the cover plate, in particular with a lower surface of the cover plate. The elastic holder may be formed as a single body and/or be made of elastic material. The elastic holder may be configured to press the sensor elastically towards a lower surface of) the cover plate. The elastic holder may be configured to elastically support the sensor to contact the cover plate. The elastic holder may be removably, or attachably and detachably, disposed in the induction heating object. The sensor may be a temperature sensor. The fuse may be a temperature fuse.

The induction heating object may comprise a working coil base disposed on the base plate and having an insertion hole in a central portion thereof, and a working coil forming a circle to surround the insertion hole and disposed on the working coil base.

A lower end portion of the holder may be fitted into and installed in the insertion hole.

An upper end portion of the holder may be disposed to protrude from an upper portion of the working coil.

The elastic holder may comprise a fuse insertion body having a fuse insertion groove, into which the fuse is inserted, therein. The elastic holder may comprise a sensor insertion body formed on one side of the fuse insertion body, having an open upper portion and having a sensor insertion hole into which the sensor is inserted. The elastic holder may further comprise a held body formed at a lower end of the sensor insertion body and fitted into and held in the insertion hole.

A lower end of the fuse insertion groove may be open along a downward direction of the fuse insertion body.

An exposure hole configured to expose the fuse insertion groove outward may be formed in an upper end portion of the fuse insertion body.

An inner width of the fuse insertion groove may be less than a width of the fuse.

The fuse insertion body may have a pair of slit grooves configured to expose both sides of the fuse insertion groove outward, in both side portions.

Each of the pair of slit grooves may be slit open from a lower end of the fuse insertion groove toward an upper end of the fuse insertion groove to a predetermined length.

The sensor insertion body may have a (cross-sectional) shape of a Z turned by 90°.

The sensor insertion body may comprise an outer body having a cylindrical shape. That is, the sensor insertion body may comprise an outer body having a central hole in an upper end portion thereof.

The sensor insertion body may comprise an extended plate body having a ring shape and extending from (e.g. an axial end or a lower end of) the outer body radially inwards. The extended plate body may be inclined with respect to a center axis of the cylindrical outer body or inclined upwards. That is, the sensor insertion body may comprise an extended plate body having a ring shape and extended from a lower end of an inner circumference of the central hole along a central axis.

An insertion body having a cylindrical shape and having the fuse insertion hole may be formed in a central portion of the extended plate body. That is, the sensor insertion body may comprise an insertion body having a cylindrical shape and extending from (a radially inner end of) the extended plate body towards the base plate, i.e. downwards.

An outer circumference of an upper end of the insertion body may be connected to the central portion of the extended plate body.

A lower end of the insertion body may be extended to a predetermined length to be disposed on a lower side of the extended plate body.

The extended plate body may incline upward from the inner circumference of the central hole toward a center of the central hole.

The held body may comprise a fitted body having a predetermined length, having a cylindrical shape and inserted into the insertion groove.

A held jaw formed on an outer circumference of a lower end of the fitted body and held at a lower end of the insertion groove.

A height of the insertion groove may be less than a length of the fitted body.

The sensor may comprise a suspension member having a ring shape and suspended at an upper end of the fuse insertion hole.

The sensor may comprise a sensing member which passes through the suspension member and an upper end portion of which is exposed to an upper end of the suspension member.

The sensor may comprise an electric cable electrically connected to the sensing member, having a predetermined length and extended through a hollow hole of the held body.

The sensor may comprise a connector installed in an end portion of the electric cable and connected to the driving circuit.

An upper surface of the sensing member may contact a lower surface of the cover plate.

The upper surface of the sensing member may be disposed higher than upper surfaces of the fuse insertion body and the sensor insertion body.

The electric cable may be surrounded by an insulation tube.

The fuse insertion body and/or the sensor insertion body may be disposed to protrude from an upper end of the working coil base.

The electric range may be an electric resistance-type electric range or an induction heating-type electric range. Directional indication, such as height, heightwise or vertical direction, width, upper end, lower end etc. refer to an orientation when the electric range is in its operative state or position. In particular, a heightwise direction can also be referred to as vertical direction. Width may denote a dimension in the horizontal direction, in particular in a horizontal direction parallel to a (vertical) front surface of the case of the electric range which will be facing a user during operation. Thus, left end and right end may denote respectively a first lateral end and a second lateral end with respect to an operative state or position of the electric range. Likewise a front end may denote an end that is closer to a user when operating the electric range, while a rear end may denote an end that is farther from a user when operating the electric range.

Specific effects are described along with the above-described effects in the section of Detailed Description.

### BRIEF DESCRIPTION OF DRAWING

The accompanying drawings constitute a part of the specification, illustrate one or more embodiments in the disclosure, and together with the specification, explain the disclosure, wherein:
FIG. 1 is a perspective view showing an electric range according to the present disclosure;
FIGS. 2 to 5 are perspective views showing the electric range in FIG. 1 without some components;
FIG. 6 is a perspective view showing an electric range having an induction heating object provided with a holder according to the present disclosure;
FIG. 7 is an enlarged perspective view showing a state in which a holder according to the present disclosure is disposed;
FIG. 8 is an exploded perspective view showing a coupling relationship between an induction heating object and a holder according to the present disclosure;
FIG. 9 is a perspective view showing a holder according to the present disclosure;
FIG. 10 is a bottom perspective view showing a holder according to the present disclosure;
FIG. 11 is a cross-sectional view along line A-A in FIG. 6; and
FIGS. 12 and 13 are perspective views showing an example in which a tube is fitted into an electric cable according to the present disclosure.

### DETAILED DESCRIPTION OF EXEMPLARY EMBODIMENT

The above-described aspects, features and advantages are specifically described hereunder with reference to the accompanying drawings such that one having ordinary skill in the art to which the present disclosure pertains can easily implement the technical spirit of the disclosure. In the disclosure, detailed descriptionof known technologies in relation to the disclosure is omitted if it is deemed to makethe gistof the disclosure unnecessarily vague. Below, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components should not be limited by the terms. Certainly, a first component can be a second component unless stated to the contrary.

When one component is described as being "in an upper portion (or a lower portion)" of another component, or "on (or under)" another component, one component can be placed on the upper surface (or under the lower surface) of another component, and an additional component may be interposed between another component and one component on (or under) another component.

When one component is described as being "connected", "coupled", or "connected" to another component, one component can be directly connected, coupled or connected to another component. However, it is also to be understood that an additional component can be "interposed" between the two components, or the two components can be "connected", "coupled", or "connected" through an additional component.

Throughout the disclosure, each component can be provided as a single one or a plurality of ones, unless explicitly stated to the contrary.

The singular forms "a", "an" and "the" are intended to include the plural forms as well, unless explicitly indicated otherwise. It should be further understood that the terms "comprise" or "have" and the like, set forth herein, are not interpreted as necessarily including all the stated components or steps but can be interpreted as including some of the stated components or steps or can be interpreted as further including additional components or steps.

Throughout the disclosure, the terms "A and/or B" as used herein can denote A, B or A and B, and the terms "C to D" can denote C or greater and D or less, unless stated to the contrary.

Below, an electric range is described with reference to several embodiments.

The electric range in the disclosure may include an electric resistance-type electric range and an induction heating-type electric range (i.e., an electric range). For convenience, an electric range, provided with a working coil as a heating unit, is described as an example during description of the embodiments. However, embodiments are not limited to those set forth herein.

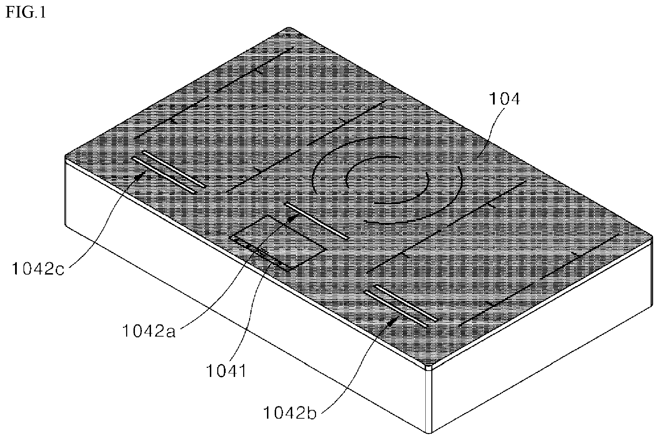

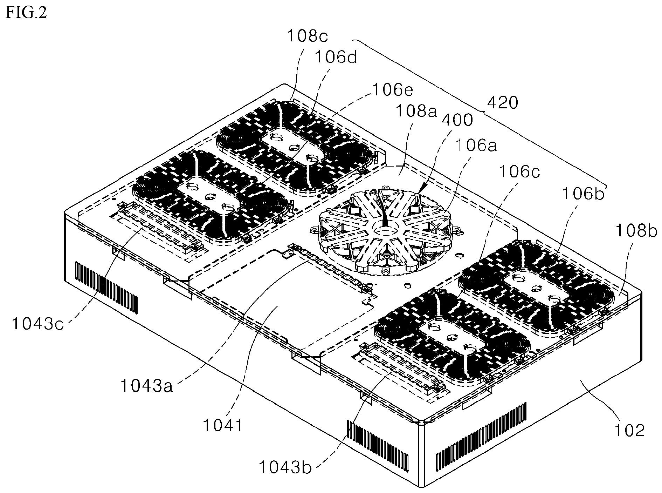

FIG. 1 is a perspective view showing an electric range 100 according to the present disclosure. FIGS. 2 to 5 are perspective views showing the electric range 100 in FIG. 1 without some components.

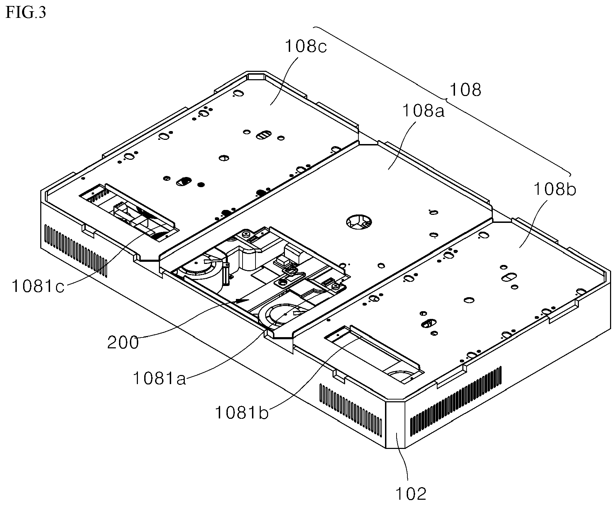

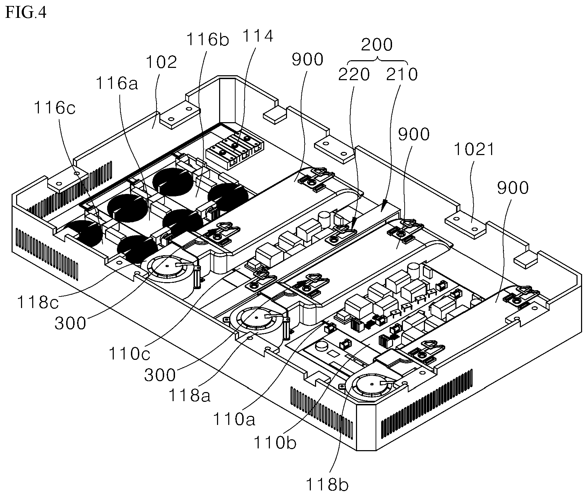

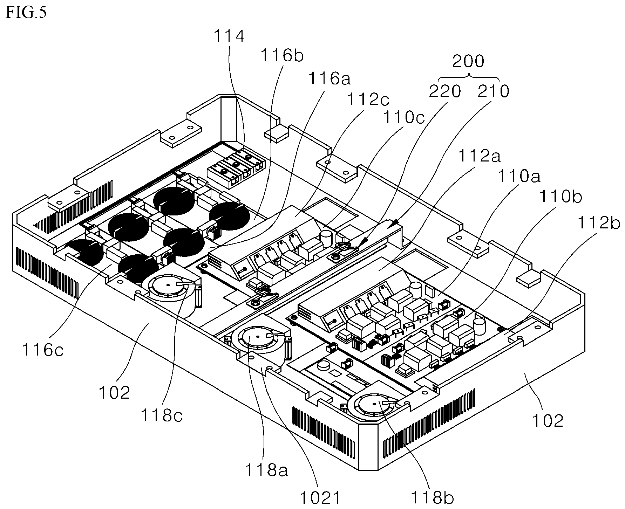

Specifically, FIG. 2 is a view showing the electric range 100 in FIG. 1 without a cover plate 104, FIG. 3 is a view showing the electric range100 in FIG. 1 without a cover plate 104 and a working coil 420, FIG. 4 is a view showing the electric range100 in FIG. 1 without a cover plate 102, a working coil 104, and a base plate 108a, 108b, 108c, and FIG. 5 is a view showing the electric range100 in FIG. 1 without a cover plate 102, a working coil 420, a base plate 108a, 108b, 108c and an air guide 600.

Referring to FIGS. 1 to 5, the electric range 100 according to one embodiment may include a case 102, a cover plate 104, a working coil 420, a base plate 108a, 108b, 108c, a driving circuit 110a, 110b, 110c, a heat sink 112a, 112b, 112c, a power feeder 114, a filter circuit 116a, 116b, 116c, an air blowing fan 118a, 118b, 118c, and air guides 600.

The case 102 may protect components in the electric range100. For example, the case 102 may be made of aluminum but not limited. The case 102 may be thermally insulated to prevent heat, generated by the working coil 420, from leaking outward.

The cover plate 104 may be coupled to an upper end of the case 102 to shield an inside of the case 102, and an object to be heated (not illustrated, an object to be heated by at least one of the working coils 420) may be placed on an upper surface of the cover plate 104.

An object to be heated such as a cooking vessel may be placed on the upper surface of the cover plate 104, and heat generated by the working coil 420 may be delivered to the object to be heated through the upper surface of the cover plate104.

The cover plate 104 may be made of glass but not limited.

An input interface 1041 configured to receive an input from a user may be disposed on the upper surface of the cover plate 104. The input interface 1041 may be buried into the upper surface of the cover plate 104 in a flat manner and may display a specific image. The input interface 1041 may receive a touch input from the user, and the electric range100 may be driven based on the received touch input.

Specifically, the input interface 1041 may be a module for inputting a heating intensity or a heating period and the like desired by the user, and may be implemented as a physical button or a touch panel and the like. Additionally, the input interface 1041 may display a driving state of the electric range 100.

For example, the input interface 1041 may be a thin film transistor liquid crystal display (TFT LCD) but not limited.

Light display areas 1042a, 1042b,1042c may be formed on the upper surface of the cover plate 104. Light source units 1043a, 1043b, 1043c may be disposed below/under the cover plate 104, and light emitted from the light source units 1043a, 1043b, 1043c may be delivered to the user through the light display areas 1042a, 1042b, 1042c.

The working coil 420 may be a heating unit that heats an object to the heated, and may be disposed in the case 102.

The working coil 420 may include a wire that is wound multiple times in a ring shape, and may generate an AC magnetic field. Additionally, a mica sheet and a ferrite core may be consecutively disposed on a lower side of the working coil 420.

The ferrite core may be fixed to the mica sheet through a sealant, and may diffuse the AC magnetic field generated by the working coil 420. The mica sheet may be fixed to the working coil 420 and the ferrite core through the sealant, and may prevent a direct delivery of the heat, generated by the working coil 420, to the ferrite core.

A plurality of working coils 420 may be provided. The plurality of working coils 420 may include a first working coil 106a disposed in a central portion of the case 102, a second working coil 106b and a third working coil 106c disposed on a right side of the first working coil 106a, and a fourth working coil 106d and a fifth working coil 106e disposed on a left side of the first working coil 106a. The second working coil 106b and the third working coil 106c may be disposed on the right side of the first working coil 106a in an up-down direction, and the fourth working coil 106d and the fifth working coil 106e may be disposed on the left side of the first working coil 106a in the up-down direction.

For example, the first working coil 106a may be a high-outputdual heating coil, and the second working coil 106b, the third working coil 106c, the fourth working coil 106d and the fifth working coil 106e may be a single heating coil. The first working coil 106a as a dual heating coil may be heavy and may have a maximum output of 7000 kW.

The electric range 100 according to one embodiment may perform the function of wireless power transmission based on the configurations and features described above.

Technologies for wirelessly supplying power have been developed and have been used for a wide range of electronic devices. A battery of an electronic device, to which the wireless power transmitting technology is applied, can be charged only by being placed on a charge pad without connecting to an additional charge connector. Accordingly, the electronic device, to which the wireless power transmitting technology is applied, requires no cord or no charger, thereby ensuring improved mobility and a reduced size and weight.

The wireless power transmitting technology can be broadly classified as an electromagnetic induction technology using a coil, a resonance technology using resonance, and a radio emission technology for converting electric energy into microwaves and delivering the microwaves, and the like. In the electromagnetic induction technology, power is transmitted using electromagnetic induction between a primary coil (e.g., a working coil) included in an apparatus for wirelessly transmitting power and a secondary coil included in an apparatus for wirelessly receiving power.

The theory of the induction heating technology of the electric range 100 is substantially the same as that of the electromagnetic induction-based wireless power transmission technology, in that an object to be heated is heated using electromagnetic induction. Accordingly, the electric range 100 according to one embodiment may perform the function of wireless power transmission as well as the function of induction heating.

The base plate 108a, 108b, 108c may be disposed at a middle end of the case 102, and the plurality of working coils 420 may be disposed on the base plates 108a, 108b, 108c. The base plate 108a, 108b, 108c may support the plurality of working coils 420 that are heavy, and may help the plurality of working coils 420 to be mounted. The input interface 1041 and the light source unit 1043a, 1043b, 1043c may be further disposed on/in the upper portion of the base plate 108a, 108b, 108c.

According to one embodiment, a plurality of base plates 108a, 108b, 108c may be provided but not limited. Alternatively, a single base plate may be disposed in the case 102.

According to one embodiment, the plurality of base plates 108a, 108b, 108c may include a first base plate 108a, a second base plate 108b, and a third base plate 108c.

The first base plate 108a, the second base plate 108b, and the third base plate 108c may be disposed at the middle end of the case 102 side by side.

The first base plate 108a may be disposed in a central portion of the middle end of the case 102. The first working coil 106a may be disposed on the first base plate 108a.

The input interface 1041, and a first light source unit 1043a corresponding to the first working coil 106a may be further disposed on the first base plate 108a. On/In the upper portion of the first base plate 108a, the input interface 1041 may be disposed on a lower side of the first light source unit 1043a, and the first light source unit 1043a may be disposed on a lower side of the input interface 1041. The first base plate 108a may have a through hole A 1081a for installing the input interface 1041 and the first light source unit 1043a.

The second base plate 108b may be disposed on a right side of the first base plate 108a at the middle end of the case 102. The second working coil 106b and the third working coil 106c may be disposed on the second base plate 108b.

A second light source unit 1043b corresponding to the second working coil 106b and the third working coil 106c may be further disposed on/in the upper portion of the second base plate 108b. On/In the upper portion of the second base plate 108b, the second working coil 106b, the third working coil 106c and the second light source unit 1043b may be consecutively disposed. The second base plate 108b may have a through hole B 1081b for installing the second light source unit 1043b.

The third base plate 108c may be disposed on a left side of the first base plate 108a at the middle end of the case 102. The fourth working coil 106d and the fifth working coil 106e may be disposed on/in an upper portion of the third base plate108c.

A third light source unit 1043c corresponding to the fourth working coil 106d and the fifth working coil 106e may be further disposed on/in the upper portion of the third base plate108c. On/In the upper portion of the third base plate108c, the fourth working coil 106d, the fifth working coil 106e and the third light source unit 1043c may be consecutively disposed. The third base plate 108c may have a through hole C 1081c for installing the third light source unit 1043c.

The case 102 may have a plurality of mounting portions 1021 for mounting the plurality of base plates 108a, 108b, 108c in portions of an outer circumferential surface of the case 102. That is, edges of the plurality of base plates 108a, 108b, 108c may be mounted onto tops of the plurality of mounting portions 1021. Accordingly, the plurality of base plates 108a, 108b, 108c may be disposed at the middle end of the case 102.

A bracket 210 may be disposed in a central portion of a lower end of the case 102. The bracket 210 may be disposed in a central portion of a lower side of the first base plate 108a, and may prevent a bend (i.e., sagging of the first base plate 108a), caused by weight of the first base plate 108a. The weight of the first base plate 108a may include the weight of the first working coil 106a on/in the upper portion of the first base plate 108a.

At least one elastic member220may be disposed on the bracket 210. For example, the elastic member 220 may be a leaf spring. An upper end of at least one elastic member 220 may contact the lower surface of the first base plate 108a, and may prevent sagging of the first base plate 108a. The configuration and mechanism for prevention of a bend are described hereunder.

The driving circuit 110a, 110b, 110c may control driving of the plurality of working coils 420 that are heating units, and may further control driving of components such as the input interface 1041 and the like of the electric range 100.

The driving circuit 110a, 110b, 110c may include various components in relation to the driving of the working coils 420. The components may include a power supply configured to supply AC power, a rectifier configured to rectify AC power of the power supply into DC power, an inverter configured to convert DC power, rectified by the rectifier, into resonance current as a result of a switching operation and supply the resonance current to the working coil 106, a microcomputer (i.e., a micom) configured to control the inverter and components in relation to driving of the inverter, a relay or a semiconductor switch configured to turn on or turn off the working coils 420, and the like.

The driving circuit 110a, 110b, 110c may include a first driving circuit 110a, a second driving circuit 110b, and a third driving circuit 110c. The first driving circuit 110a may be disposed on a right side of the lower end of the case 102 with respect to the bracket 210 and may control driving of the first working coil 106a. The second driving circuit 110b may be disposed on a right side of the first driving circuit 110a and may control driving of the second working coil 106b and the third working coil 106c. The third driving circuit 110c may be disposed on a left side of the lower end of the case 102 with respect to the bracket 210 and may control driving of the fourth working coil 106d and the fifth working coil 106e.

The heat sink 112a, 112b, 112c may be disposed over a portion of the driving circuit 110a, 110b, 110c and may prevent an increase in temperatures of components disposed in a portion of the driving circuit 110a, 110b, 110c.

The heat sink 112a, 112b, 112c may include a first heat sink 112a, a second heat sink 112b, and a third heat sink 112c. The first heat sink 112a may prevent an increase in temperatures of components installed in a portion of the first driving circuit 110a, the second heat sink 112b may prevent an increase in temperatures of components installed in a portion of the second driving circuit 110b, and the third heat sink 112c may prevent an increase in temperatures of components installed in a portion of the third driving circuit 110c.

The power feeder 114 may supply an external power source to the electric range 100. The power feeder 114 may be implemented as a terminal block.

The power feeder 114 may be disposed at any one of edges of the lower end of the case 102. For example, the power feeder 114 may be disposed at an upper end of the left side of the lower end of the case 102.

The filter circuit 116a, 116b, 116c may be disposed at any one of the edges of the lower end of the case 102, and may reduce noise made by the plurality of working coils 420.

The filter circuit 116a, 116b, 116c may include a first filter circuit 116a, a second filter circuit 116b, and a third filter circuit 116c.

The first filter circuit 116a may reduce noise made by the first working coil 106a. The second filter circuit 116b may reduce noise made by the second working coil 106b and the third working coil 106c. The third filter circuit 116c may reduce noise made by the fourth working coil 106d and the fifth working coil 106e.

The air blowing fan 118a, 118b, 118c may pull down a temperature inside the case 102. Accordingly, the air blowing fan 118a, 118b, 118c may lower a temperature of various components installed in the driving circuit 110a, 110b, 110c.

The air blowing fan 118a, 118b, 118c may include a first air blowing fan 118a, a second air blowing fan 118b, and a third air blowing fan 118c.

The first air blowing fan 118a may cool various components installed in the first driving circuit 110a and may further cool the light source unit 1043corresponding to the first working coil 106a. In particular, the first air blowing fan 118a may deliver air (wind) for cooling to the first heat sink 112a over the first driving circuit 110a.

The second air blowing fan 118b may cool various components installed in the second driving circuit 110b and may further cool the light source unit 1043 corresponding to the second working coil 106b and the third working coil 106c. In particular, the second air blowing fan 118b may deliver air for cooling to the second heat sink 112b over the second driving circuit 110b.

The third air blowing fan 118c may cool various components installed in the third driving circuit 110c and may further cool the light source unit 1043 corresponding to the fourth working coil 106d and the fifth working coil 106e. In particular, the third air blowing fan 118c may deliver air for cooling to the third heat sink 112c over the third driving circuit 110c.

The air blowing fan 118a, 118b, 118c may not be provided with a structure for preventing a foreign substance from contacting the air blowing fan 118a, 118b, 118c.

The air guide 600 may guide air (wind) generated by the air blowing fan 118a, 118b, 118c.

The air guide 600 may include a first air guide 600, a second air guide 600 and a third guide 600.

The first air guide 600 may be disposed to encircle the first heat sink 112a installed over a portion of the first driving circuit 110a and may guide (deliver) air, output from the first air blowing fan 118a, to the first heat sink 112a.

The second air guide 600 may be disposed to encircle the second heat sink 112b installed over a portion of the second driving circuit 110b and may guide air, output from the second air blowing fan 118b, to the second heat sink 112b.

The third air guide 600 may be disposed to encircle the third heat sink 112c installed over a portion of the third driving circuit 110c and may guide air, output from the third air blowing fan 118c, to the third heat sink 112c.

Elastic supporters 300 may be disposed at different positions of an upper end of the air guide 600. The elastic supporters 300 may be formed into a leaf spring. The elastic supporters 300 may elastically support lower surfaces of the base plates 108a, 108b, 108c on/over the air guide 600. The elastic supporters 300 may support lower surfaces of central portions of the base plates 108a, 108b, 108c. For example, the elastic supporters 300 may support positions of the lower surfaces of the central portions of the working coils 420 disposed at upper ends of the base plates 108a, 108b, 108c.

Additionally, the case 102 may be provided with a supporter 200. The supporter 200 may have a bracket 210 and elastic members 220. The bracket 210 may have a predetermined length along a widthwise direction of the base plate 108a, 108b, 108c. The elastic members 220 may be disposed at a plurality of positions of an upper end of the bracket 210. The elastic member 220 may be a leaf spring. The elastic members 220 may be disposed at a plurality of positions of the upper end of the bracket 210 and may elastically support a lower surface of a central portion of the base plate108a, 108b, 108c. The elastic members 220 may support a position corresponding to a lower surface of a central portion of the working coil 420 at an upper end of the base plate 108a, 108b, 108c, for example.

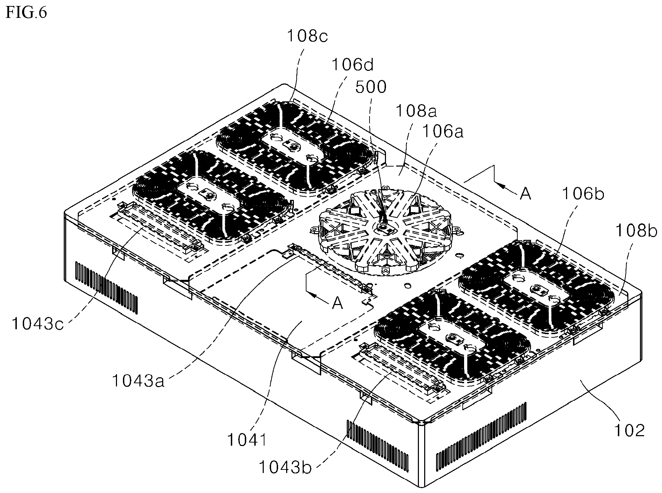

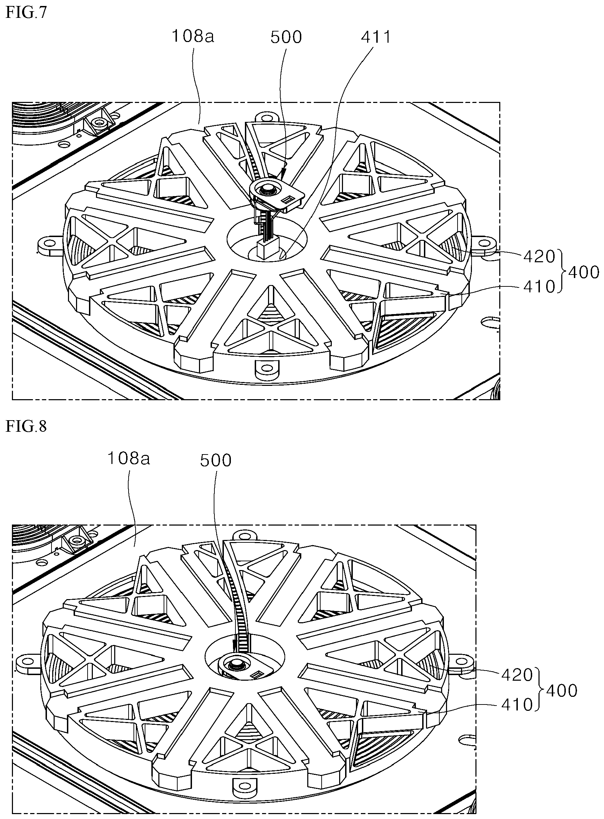

FIG. 6 is a perspective view showing an electric range having an induction heating object provided with a holder according to the present disclosure. FIG. 7 is an enlarged perspective view showing a state in which a holder according to the present disclosure is disposed. FIG. 8 is an exploded perspective view showing a coupling relationship between an induction heating object and a holder according to the present disclosure.

Referring to FIG. 6, the electric range according to the present disclosure may include a case 102, a driving circuit 110a, 110b, 110c, a base plate 108a, 108b, 108c, an induction heating object 400, a cover plate 104 and an elastic holder 500.

The case 102, the driving circuit 110a, 110b, 110c, the base plate 108a, 108b, 108c, and the cover plate 102 have the same configurations as those described with reference to FIGS. 1 to 5.

The driving circuit 110a, 110b, 110c may be disposed in the case 102. A plurality of driving circuits 110a, 110b, 110c described above may be provided.

A plurality of base plates 108a, 1089b, 108c described above may be provided. The plurality of base plates 108, 108b, 108c may be disposed at an upper end of the case 102 in a way that the plurality of base plates 108, 108b, 108c are adjacent to one another.

The induction heating object 400 according to the present disclosure may include a working coil base 410 and a working coil 420.

The working coil base 410 may be disposed at an upper end of the base plate 108, 108b, 108c. The base plate 108, 108b, 108c may have an insertion hole 411 in a central portion thereof. The insertion hole 411 may have a circular shape. The base plate 108, 108b, 108c may have a through hole 108d communicating with the insertion hole 411.

The through hole 108d may be exposed to the above-described driving circuit 110a, 100b, 110c.

The working coil 420 may be disposed around the insertion hole 411 in a circular shape.

An upper surface portion of the working coil 410 may be spaced from a lower surface of the cover plate 102.

Referring to FIGS. 7 and 8, the holder 500 according to the present disclosure may be inserted into and fixed to the insertion hole 411 formed in a central portion of the working coil base 410. Accordingly, the holder 500 may be disposed at a center of the induction heating object 400.

That is, the holder 500 may have a structure, in which the holder 500 is fitted into and fixed to or escapes from the insertion hole 411 and the through hole 108d that are formed in a central portion of the working coil 420,above the working coil base 410.

The holder 500 may be respectively inserted into and fixed to the central portion of the first, second, third, fourth and fifth working coils 420. The first, second, third, fourth and fifth working coils may be indicated by the same reference numeral of "420".

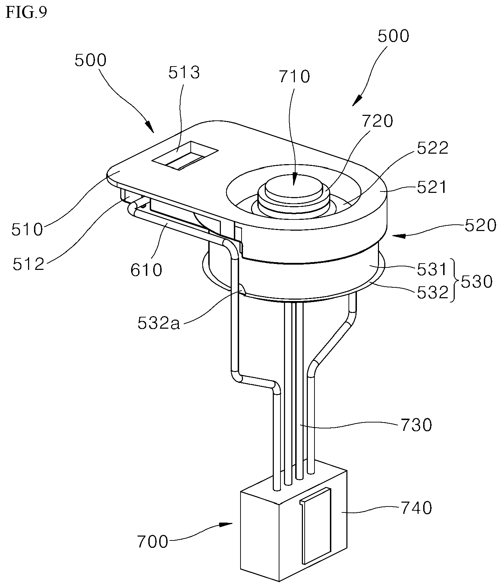

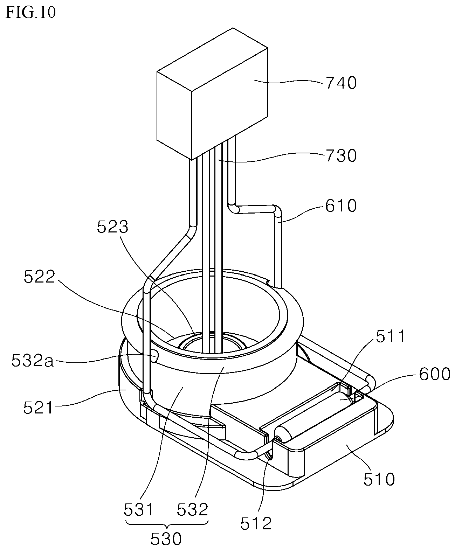

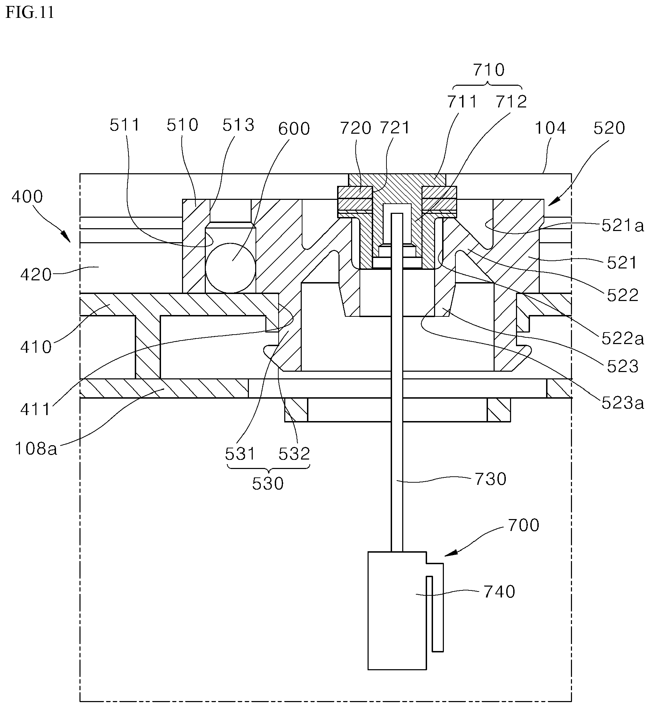

FIG. 9 is a perspective view showing a holder according to the present disclosure. FIG. 10 is a bottom perspective view showing a holder according to the present disclosure. FIG. 11 is a cross-sectional view along line A-A in FIG. 6.

A configuration of the holder 500 according to the present disclosure is described with reference to FIGS. 9 to 11.

The holder 500 may be made of an elastic material. The holder 500 may have insulation and thermal resistant properties.

The holder 500 may have a fuse insertion body 510, a sensor insertion body 520 and a held body 530. The fuse insertion body 510, the sensor insertion body 520 and the held body 530 may be integrally formed based on injection molding.

The fuse insertion body 510 is described hereunder.

A fuse insertion groove 511 may be formed in the fuse insertion body 510. A lower portion of the fuse insertion groove 511 may be open along a downward direction of the fuse insertion body 510. A fuse 600 may be inserted into the fuse insertion groove 511 through the open lower portion of the fuse insertion groove 511.

The fuse 600 may have a predetermined length and have a circular rod-shaped body or a rectangle-shaped body. The fuse insertion groove 511 may be formed into a shape corresponding to a shape of an outer circumference of the fuse.

Additionally, a pair of slit grooves 512 may be formed in both side portions of the fuse insertion body 510. The pair of slit grooves 512 may expose both sides of the fuse insertion groove 511. The pair of slit grooves 512 may be respectively slitopen to a predetermined length from a lower end of the fuse insertion groove 511 to an upper end thereof.

The pair of slit grooves 512 may guide a signal line 610 connected to both ends of the fuse 600 such that the signal line 610 protrudes outward. Additionally, the pair of slit grooves 512 may guide the signal line such that the signal line moves in an up-down direction.

Further, an inner width of the fuse insertion groove 511 may be less than a width of the fuse 600.The fuse 600 may be elastically pressed against an inner wall of the fuse insertion groove 511 having elasticity. The fuse 600 may be fixed to the fuse insertion groove 511 using the elasticity. The fuse insertion body 510 may protect the fuse 600 from an external impact. The fuse insertion groove 511 may be formed into a shape corresponding to a shape of a circumference of the fuse 600.

Additionally, an exposure hole 513 may be made in an upper end portion of the fuse insertion body 510. The exposure hole 513 may communicate with the fuse insertion groove 511. The exposure hole 513 may have a size less than a size of the fuse insertion groove 511. The fuse 600 may be inserted into the fuse insertion groove 511. The exposure hole 513 may expose a portion of the fuse outward.

The sensor insertion body 520 may be integrally formed on one side of the fuse insertion body 510 according to the present disclosure.

The sensor insertion body 520 may have an outer body 521,an extended plate body 522 and an insertion body 523.

The outer body 521 may be integrally formed on one side of the fuse insertion body 510.

The outer body 521 may have a cylindrical shape, as a whole. The outer body 521 may have a central hole 521a in an upper end portion thereof. The central hole 521a may be formed into a circular hole.

The extended plate body 522 may extend from an inner circumference of the central hole 521a along a center of the central hole 521a. The extended plate body 522 may be formed into a circular plate. The extended plate body 522 may have a circular hole 522a in a central portion thereof.

The insertion body 523 may have a cylindrical shape. An upper end of the insertion body 523 having a cylindrical shape may integrally connect to an inner circumference of the circular hole 522a. The insertion body 523 may extend to a predetermined length along the downward direction.

The extended plate body 522 may incline upward from the inner circumference of the central hole 521a toward the center of the central hole 521a.

A sensor 700 according to the present disclosure may be a temperature sensor.

The sensor 700 may have a sensing member 710, a ring-shaped suspension member 720, an electric cable 730 and a connector 740.

The sensing member 710 may have an upper end sensing body 711 and a lower end sensing body 712. The upper end sensing body 711 may be formed as a circular plate. The lower end sensing body 712 may be formed a sa circular rod. An upper end of the lower end sensing body 712 may connect to a lower end of the upper end sensing body 711. The sensing member 710 may be formed to have a cross section of a "T" shape, as a whole. The upper end sensing body 711 and the lower end sensing body 712 may be integrally formed.

The suspension member 720 may be formed to have a hollow hole, i.e. formed in a hollow shape. A step or stepped portion may be formed around the suspension member 720, i.e. formed on an outer periphery of the suspension member 720. That is, the suspension member 720 may be formed as a hollow cylinder having a stepped portion extending from an upper end of the hollow cylinder radially outwards. The stepped portion may be supported by the sensor insertion body 520.

The lower end sensing body 712 may be fitted into the hollow hole or hollow cylinder 721 of the suspension member 720. The lower end of the upper end sensing body 711 may be suspended at or supported by an upper end of the suspension member 720, e.g. by an upper end of the hollow cylinder and/or by the stepped portion.

The suspension member 720, in particular the hollow cylinder 721 thereof, may be fitted into a hole 523a of the insertion body 523. The stepped portion of the suspension member 720 may be mounted onto the upper end of the insertion body 523.

Additionally, a circumference of the suspension member 720 may come into close contact with the hollow hole 523a of the insertion body 523. The suspension member 720, and the hollow hole 523a of the insertion body 523 may be configured to be suspended using the step.

Accordingly, the sensor 700 according to the disclosure may be fitted into and/or fixed to the insertion body 523 of the sensor insertion body 520. An upper surface of the sensing member 710 of the sensor 700 may protrude from the upper surface of the sensor insertion body 720.

The electric cable 730 connected to the sensing member 710 may extend downward to a predetermined length through the hollow hole 523a of the insertion body 523.

The held body 530 according to the present disclosure may be integrally formed with the sensor insertion body 520, e.g. at a lower end of the sensor insertion body 520.

The held body 530 may have a fitted body 531 and a held jaw 532. The fitted body 531 may have a predetermined length, may have a cylindrical shape and may be inserted into the insertion hole 411of the induction heating object 400 or the working coil base 410.

The held jaw 532 may protrude from an outside of a lower end of the fitted body 531 along an outer circumference of the fitted body 531. The held jaw 532 may be held at a lower end of the insertion hole 411 formed in the induction heating object 400.

The insertion hole 411 may have a height less than the length of the fitted body 531.

Additionally, the held jaw 532 may have a guide groove 532a. The number of the guide grooves 532a may correspond to the number of the signal lines 610 of the fuse 600. The guide groove 532a may be formed into a slit that is slit open on an outer circumference of the held jaw 532. The signal line 610 is disposed may be fitted into the guide groove 532a and may be guided.

The guide groove may be made at the held jaw. In this case, the signal line may pass through the guide groove.

The electric cable passing through the hollow hole 523a of the insertion body 523 may extend outward through a hollow hole of the held body 530.

The connector 740 according to the present disclosure may connect to an end portion of the electric cable 730. The electric cable 730 may pass through the through hole 108d formed at the base plate 108a, 108b, 108c. The connector 740 in the end portion of the electric cable 730 may connect to the driving circuit 110a, 110b, 110c in the case 102.

According to the present disclosure, a fuse and a sensor may be provided in a single body having elasticity, and may be fitted into and installed in an insertion hole of an induction heating object based on the above-described configurations and mechanisms, thereby ensuring ease of installation and convenience of repairs and maintenance.

According to the present disclosure, the sensor may be elastically supported, and an upper end of the sensor may be disposed in close contact with a lower surface of a cover plate that is an upper plate, thereby improving sensing efficiency and offsetting an impact applied to the sensor and the cover plate.

According to the present disclosure, a temperature fuse and a temperature sensor may be installed in a single holder that has elasticity and is disposed at an upper end of an induction heating object, thereby absorbing an external impact and preventing the temperature fuse and temperature sensor from escaping.

According to the present disclosure, the temperature sensor may elastically come into close contact with the lower surface of the cover plate, thereby preventing damage to the cover plate by an impact.

According to the present disclosure, a sensing surface of an upper end of the temperature sensor may come into close contact with the lower surface of the cover plate, thereby preventing the temperature fuse from begin blown when the temperature sensor overheats due to damage to the temperature sensor.

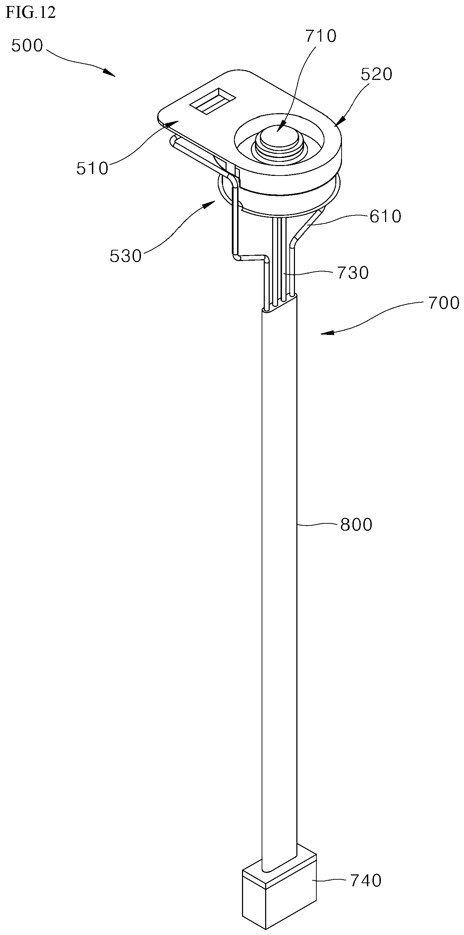

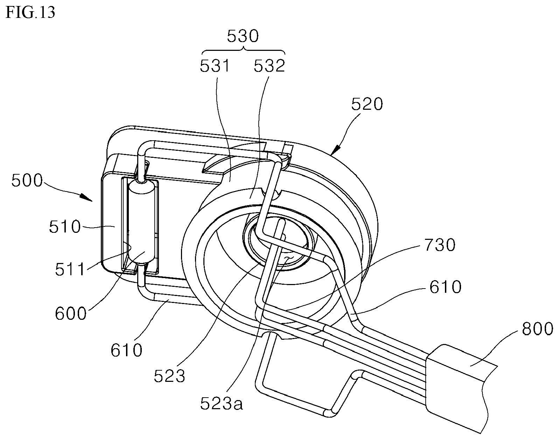

FIGS. 12 and 13 are perspective views showing an example in which a tube is fitted into an electric cable according to the present disclosure.

Referring to FIGS. 12 and 13, the sensor 700 according to the disclosure may have an electric cable 730. The fuse 600 may have signal lines 610 having a predetermined length, at both ends thereof. FIG. 6 is a perspective view showing an electric range having an induction heating object provided with a holder according to the present disclosure. FIG. 7 is an enlarged perspective view showing a state in which a holder according to the present disclosure is disposed. FIG. 8 is an exploded perspective view showing a coupling relationship between an induction heating object and a holder according to the present disclosure.

FIG. 9 is a perspective view showing a holder according to the present disclosure. FIG. 10 is a bottom perspective view showing a holder according to the present disclosure. FIG. 11 is a cross-sectional view showing a holder according to the present disclosure. FIG. 12 is a cross-sectional view along the line A-A in FIG. 7. FIG. 13 is an enlarged cross-sectional view showing portion A in FIG. 12.

FIGS. 14 and 15 are perspective views showing an example in which a tube is fitted into an electric cable according to the present disclosure.

End portions of the electric cable 730 and the signal line 610 may connect to the connector.

When the electric cable 730 and the signal line 610 have a predetermined length or greater relative to FIG. 9, the electric cable 730 and the signal line 610 may be wrapped by an insulation tube 800 having a hollow hole. The insulation tube 800 may have elasticity. Accordingly, the electric cable 730 and the signal line 610 may be elastically tightened in a state of being fitted into and surrounded by the hollow hole of the insulation tube 800 and may be tidied up. Additionally, the insulation tube 800 may protect the electric cable 730 and the signal line 610 from damage caused by an electric effect such as a spark.

**[Description of Symbol]**

| | | | |
|---|---|---|---|
| 100: | Electric range | 102: | Case |
| 1021: | Mounting portion | 1023a: | 1-1th through hole |
| 1023b: | 1-2th through hole | 1023c: | 1-3th through hole |
| 1024a: | 2-1th through hole | 1024b: | 2-2th through hole |
| 1024c: | 2-3th through hole | 104: | Cover plate |
| 1041: | Input interface | 1042a: | First light display area |
| 1042b: | Second light display area | 1042c: | Third light display area |
| 1043a: | First light source unit | 1043b: | Second light source unit |
| 1043c: | Third light source unit | 106a: | First working coil |
| 106b: | Second working coil | 106c: | Third working coil |
| 106d: | Fourth working coil | 106e: | Fifth working coil |
| 108a: | First base plate | 108b: | Second base plate |
| 108c: | Third base plate | 110a: | First driving circuit |
| 110b: | Second driving circuit | 110c: | Third driving circuit |
| 112a: | First heat sink | 112b: | Second heat sink |
| 112c: | Third heat sink | 114: | Power feeder |
| 116a: | First filter circuit | 116b: | Second filter circuit |
| 116c: | Third filter circuit | 118a: | First air blowing fan |
| 118b: | Second air blowing fan | 118c: | Third air blowing fan |
| 200: | Supporter | 210: | Bracket |
| 220: | Elastic member | 300: | Elastic supporter |
| 400: | Induction heating object | 410: | Working coil base |
| 411: | Insertion hole | 420: | Working coil |
| 500: | Holder | 510: | Fuse insertion body |
| 511: | Fuse insertion groove | 512: | Slit groove |
| 513: | Exposure hoe | 520: | Sensor insertion body |
| 521: | Outer body | 522: | Extended plate body |
| 523: | Insertion body | 600: | Air guide |
| 700: | Sensor | 710: | Sensing member |
| 720: | Suspension member | 730: | Electric cable |
| 740: | Connector | | |

## Claims

1. An electric range, comprising:
a case (102) having an inner space;
a driving circuit (110a, 110b, 110c) disposed in the inner space of the case (102);
a base plate (108a, 108b, 108c) disposed in the case on the driving circuit (110a, 110b, 110c);
an induction heating object (400) disposed on the base plate (108a, 108b, 108c);
a cover plate (104) disposed on the induction heating object (400); **characterised by**
an elastic holder (500) disposed in an insertion hole (411) within the induction heating object (400), and accommodating a fuse (600) and a sensor (700), wherein the sensor (700) contacts the cover plate (104).

2. The electric range of claim 1, wherein the induction heating object (400) comprises:
a working coil base (410) disposed on the base plate (108a, 108b, 108c) and having the insertion hole (411) in a central portion thereof, and
a working coil (420) surrounding the insertion hole (411) and disposed on the working coil base (410), and
wherein a lower end portion of the holder (500) is installed in the insertion hole (411) and an upper end portion of the holder (500) protrudes from the working coil (420).

3. The electric range of claim 1 or 2, wherein the holder (500) comprises:
a sensor insertion body (520) having a sensor insertion hole into which the sensor (700) is inserted,
a fuse insertion body (510) having a fuse insertion groove (511), into which the fuse (600) is inserted, and being formed on one side of the sensor insertion body (520), and
a held body (530) extending from the sensor insertion body (520) towards the base plate (108a) and being fitted in the insertion hole (411) of the induction heating object (400).

4. The electric range of claim 3, wherein the fuse insertion groove (511) is open towards the base plate (108a, 108b, 108c), and/or
wherein an exposure hole (513) exposing the fuse insertion groove (511) towards the cover plate (104) is formed in the fuse insertion body (510).

5. The electric range of claim 3or 4, wherein an inner width of the fuse insertion groove (511) is less than a width of the fuse (600).

6. The electric range of claim 3, 4, or 5, wherein the fuse insertion body (510) has a slit groove (512) formed at opposite ends of the fuse insertion groove (511), each slit groove (512) extending from a lower end of the fuse insertion groove (511) toward an upper end thereof and/or having a smaller width than the fuse insertion groove (511).

7. The electric range according to any of claims 4-6 when depending on claim 3,
wherein the sensor insertion body (520) comprises an outer body (521) having a cylindrical shape, an extended plate body (522) having a ring shape and extending radially inwards from the outer body (521), and an insertion body (523) having a cylindrical shape and extending from the extended plate body (522) towards the base plate (108a, 108b, 108c).

8. The electric range of claim 7, wherein an upper end of the insertion body (523) is connected to a radially inner end of the extended plate body (522), and/or
wherein a lower end of the insertion body (523) is extended further towards the base plate (108a, 108b, 108c) than the extended plate body (522).

9. The electric range of claim 7 or 8, wherein the extended plate body (522) is inclined upward from a lower end of the outer body (521) towards a center axis of the outer body (521).

10. The electric range according to any of claims 4-9 when depending on claim 3, wherein the held body (530) comprises a fitted body (531)having a cylindrical shape and being inserted into the insertion hole (411), and a held jaw (532) protruding from an outer circumference of a lower end of the fitted body (531) and held by the insertion hole (411).

11. The electric range of claim 10, wherein a vertical length of the insertion groove (411) is less than a vertical length of the fitted body (531).

12. The electric range according to any of claims 4-11 when depending on claim 3, wherein the sensor (700) comprises:
a suspension member (720) having a ring shape and being suspended at the sensor insertion body (520),
a sensing member (710) which passes through the suspension member (720) and having an upper end portion which is exposed by the suspension member (720),
an electric cable(730) electrically connected to the sensing member (710)and extending through the sensor insertion body (520), and
a connector (740)at an end portion of the electric cable (730) and connected to the driving circuit (110a, 110b, 110c), and
wherein the upper end portion of the sensing member (710) is in contact with the cover plate (104).

13. The electric range of claim 12, wherein the upper end portion of the sensing member (710) protrudes from the suspension member (720) and/or from the sensor insertion body (520).

14. The electric range of claim 12 or 13, wherein the electric cable (730) is surrounded by an insulation.

15. The electric range according to any of claims 4-14 when depending on claim 3, wherein the fuse insertion body (510) and/or the sensor insertion body (520) protrude from the working coil base (410) and/or from the working coil (420).

## Patentansprüche

1. Elektroherd, der Folgendes umfasst:
ein Gehäuse (102), das einen Innenraum hat;
eine Ansteuerschaltung (110a, 110b, 110c), die im Innenraum des Gehäuses (102) angeordnet ist;
eine Basisplatte (108a, 108b, 108c), die im Gehäuse auf der Ansteuerschaltung (110a, 110b, 110c) angeordnet ist;
ein Induktionsheizobjekt (400), das auf der Basisplatte (108a, 108b, 108c) angeordnet ist;
eine Abdeckplatte (104), die auf dem Induktionsheizobjekt (400) angeordnet ist;
**gekennzeichnet durch**:
eine elastische Halterung (500), die in einem Einsetzloch (411) im Induktionsheizobjekt (4) angeordnet ist und eine Sicherung (600) sowie einen Sensor (700) aufnimmt, wobei der Sensor (700) mit der Abdeckplatte (104) in Kontakt ist.

2. Elektroherd nach Anspruch 1, wobei das Induktionsheizobjekt (400) Folgendes umfasst:
eine Arbeitsspulenbasis (410), die auf der Basisplatte (108a, 108b, 108c) angeordnet ist und in einem zentralen Abschnitt das Einsetzloch (411) aufweist, und
eine Arbeitsspule (420), die das Einsetzloch (411) umgibt und auf der Arbeitsspulenbasis (410) angeordnet ist,
wobei ein unterer Endabschnitt der Halterung (500) im Einsetzloch (411) installiert ist und ein oberer Endabschnitt der Halterung (500) von der Arbeitsspule (420) vorsteht.

3. Elektroherd nach Anspruch 1 oder 2, wobei die Halterung (500) Folgendes umfasst:
einen Sensoreinsetzkörper (520), der ein Sensoreinsetzloch hat, in das der Sensor (700) eingesetzt wird,
einen Sicherungseinsetzkörper (510), der eine Sicherungseinsetzrinne (511) hat, in die die Sicherung (600) eingesetzt wird und die auf einer Seite des Sensoreinsetzkörpers (520) ausgebildet ist, und
einen Haltekörper (530), der sich vom Sensoreinsetzkörper (520) zur Basisplatte (108a) erstreckt und in das Einsetzloch (411) des Induktionsheizobjekts (400) eingepasst ist.

4. Elektroherd nach Anspruch 3, wobei die Sicherungseinsetzrinne (511) zur Basisplatte (108a, 108b, 108c) hin offen ist und/oder
wobei ein Loch (513) zum Freilegen, das die Sicherungseinsetzrinne (511) zur Abdeckplatte (104) hin freilegt, im Sicherungseinsetzkörper (510) ausgebildet ist.

5. Elektroherd nach Anspruch 3 oder 4, wobei eine innere Breite der Sicherungseinsetzrinne (511) kleiner als eine Breite der Sicherung (600) ist.

6. Elektroherd nach Anspruch 3, 4 oder 5, wobei der Sicherungseinsetzkörper (510) eine eingeschnittene Kerbe (512) hat, die an entgegengesetzten Enden der Sicherungseinsetzrinne (511) ausgebildet ist, wobei jede eingeschnittene Kerbe (512) von einem unteren Ende der Sicherungseinsetzrinne (511) zu einem oberen Ende verläuft und/oder eine kleinere Breite als die Sicherungseinsetzrinne (511) hat.

7. Elektroherd nach einem der Ansprüche 4-6, wenn abhängig von Anspruch 3,
wobei der Sensoreinsetzkörper (520) einen Außenkörper (521), der eine zylindrische Form hat, einen ausgedehnten Plattenkörper (522), der eine Ringform hat und sich vom Außenkörper (521) radial nach innen erstreckt, und einen Einsetzkörper (523), der eine zylindrische Form hat und vom ausgedehnten Plattenkörper (522) zur Basisplatte (108a, 108b, 108c) verläuft, umfasst.

8. Elektroherd nach Anspruch 7, wobei ein oberes Ende des Einsetzkörpers (523) mit einem radial inneren Ende des ausgedehnten Plattenkörpers (522) verbunden ist und/oder
wobei sich ein unteres Ende des Einsetzkörpers (523) weiter als der ausgedehnte Plattenkörper (522) zur Basisplatte (108a, 108b, 108c) erstreckt.

9. Elektroherd nach Anspruch 7 oder 8, wobei der ausgedehnte Plattenkörper (522) von einem unteren Ende des Außenkörpers (521) zur Mittelachse des Außenkörpers (521) aufwärts geneigt ist.

10. Elektroherd nach einem der Ansprüche 4-9, wenn abhängig von Anspruch 3, wobei der Haltekörper (530) einen Passkörper (531), der eine zylindrische Form hat und in das Einsetzloch (411) eingesetzt ist, und eine Haltebacke (532), die von einem Außenumfang eines unteren Endes des Passkörpers (531) vorsteht und durch das Einsetzloch (411) gehalten wird, umfasst.

11. Elektroherd nach Anspruch 10, wobei eine vertikale Länge der Einsetzrinne (411) kürzer als eine vertikale Länge des Passkörpers (531) ist.

12. Elektroherd nach einem der Ansprüche 4-11, wenn abhängig von Anspruch 3, wobei der Sensor (700) Folgendes umfasst:
ein Aufhängungselement (720), das eine Ringform hat und am Sensoreinsetzkörper (520) hängt,
ein Messelement (710), das durch das Aufhängungselement (720) verläuft und einen oberen Endabschnitt hat, der durch das Aufhängungselement (720) freiliegt,
ein Elektrokabel (730), das mit dem Messelement (710) elektrisch verbunden ist und durch den Sensoreinsetzkörper (520) verläuft, und
ein Verbindungselement (740) an einem Endabschnitt des Elektrokabels (730), das mit der Ansteuerschaltung (110a, 110b, 110c) verbunden ist,
wobei der obere Endabschnitt des Messelements (710) mit der Abdeckplatte (104) in Kontakt ist.

13. Elektroherd nach Anspruch 12, wobei der obere Endabschnitt des Messelements (710) vom Aufhängungselement (720) und/oder vom Sensoreinsetzkörper (520) vorsteht.

14. Elektroherd nach Anspruch 12 oder 13, wobei das Elektrokabel (730) von einer Isolierung umgeben ist.

15. Elektroherd nach einem der Ansprüche 4-14, wenn abhängig von Anspruch 3, wobei der Sicherungseinsetzkörper (510) und/oder der Sensoreinsetzkörper (520) von der Arbeitsspulenbasis (410) und/oder von der Arbeitsspule (420) vorstehen.

## Revendications

1. Cuisinière électrique, comportant :
une enveloppe (102) ayant un espace intérieur ;
un circuit de commande (110a, 110b, 110c) disposé dans l'espace intérieur de l'enveloppe (102) ;
une plaque de base (108a, 108b, 108c) disposée dans l'enveloppe sur le circuit de commande (110a, 110b, 110c) ;
un objet de chauffage par induction (400) disposé sur la plaque de base (108a, 108b, 108c) ;
une plaque de recouvrement (104) disposée sur l'objet de chauffage par induction (400) ;
**caractérisée par**
un support élastique (500) disposé dans un trou d'insertion (411) à l'intérieur de l'objet de chauffage par induction (400), et recevant un fusible (600) et un capteur (700),
dans laquelle le capteur (700) vient en contact avec la plaque de recouvrement (104).

2. Cuisinière électrique selon la revendication 1, dans laquelle l'objet de chauffage par induction (400) comporte :
une base de bobine de travail (410) disposée sur la plaque de base (108a, 108b, 108c) et ayant le trou d'insertion (411) dans une partie centrale de celle-ci, et
une bobine de travail (420) entourant le trou d'insertion (411) et disposée sur la base de bobine de travail (410), et
dans laquelle une partie d'extrémité inférieure du support (500) est installée dans le trou d'insertion (411) et une partie d'extrémité supérieure du support (500) fait saillie à partir de la bobine de travail (420).

3. Cuisinière électrique selon la revendication 1 ou 2, dans laquelle le support (500) comporte :
un corps d'insertion de capteur (520) ayant un trou d'insertion de capteur dans lequel le capteur (700) est inséré,
un corps d'insertion de fusible (510) ayant une rainure d'insertion de fusible (511), dans laquelle le fusible (600) est inséré, et étant formée sur un côté du corps d'insertion de capteur (520), et
un corps maintenu (530) s'étendant à partir du corps d'insertion de capteur (520) vers la plaque de base (108a) et étant monté dans le trou d'insertion (411) de l'objet de chauffage par induction (400).

4. Cuisinière électrique selon la revendication 3, dans laquelle la rainure d'insertion de fusible (511) est ouverte vers la plaque de base (108a, 108b, 108c), et/ou
dans laquelle un trou d'exposition (513) exposant la rainure d'insertion de fusible (511) vers la plaque de recouvrement (104) est formé dans le corps d'insertion de fusible (510).

5. Cuisinière électrique selon la revendication 3 ou 4, dans laquelle une largeur intérieure de la rainure d'insertion de fusible (511) est inférieure à une largeur du fusible (600).

6. Cuisinière électrique selon la revendication 3, 4 ou 5, dans laquelle le corps d'insertion de fusible (510) a une rainure de fente (512) formée à des extrémités opposées de la rainure d'insertion de fusible (511), chaque rainure de fente (512) s'étendant à partir d'une extrémité inférieure de la rainure d'insertion de fusible (511) vers une extrémité supérieure de celle-ci et/ou ayant une largeur plus petite que la rainure d'insertion de fusible (511).

7. Cuisinière électrique selon l'une quelconque des revendications 4 à 6 lorsqu'elle dépend de la revendication 3, dans laquelle le corps d'insertion de capteur (520) comporte un corps extérieur (521) ayant une forme cylindrique, un corps de plaque étendu (522) ayant une forme annulaire et s'étendant radialement vers l'intérieur à partir du corps extérieur (521), et un corps d'insertion (523) ayant une forme cylindrique et s'étendant à partir du corps de plaque étendu (522) vers la plaque de base (108a, 108b, 108c).

8. Cuisinière électrique selon la revendication 7, dans laquelle une extrémité supérieure du corps d'insertion (523) est reliée à une extrémité radialement intérieure du corps de plaque étendu (522), et/ou
dans laquelle une extrémité inférieure du corps d'insertion (523) s'étend vers la plaque de base (108a, 108b, 108c) plus loin que le corps de plaque étendu (522).

9. Cuisinière électrique selon la revendication 7 ou 8, dans laquelle le corps de plaque étendu (522) est incliné vers le haut à partir d'une extrémité inférieure du corps extérieur (521) vers un axe central du corps extérieur (521).

10. Cuisinière électrique selon l'une quelconque des revendications 4 à 9 lorsqu'elle dépend de la revendication 3, dans laquelle le corps maintenu (530) comporte un corps monté (531) ayant une forme cylindrique et étant inséré dans le trou d'insertion (411), et une mâchoire maintenue (532) faisant saillie à partir d'une circonférence extérieure d'une extrémité inférieure du corps monté (531) et maintenue par le trou d'insertion (411).

11. Cuisinière électrique selon la revendication 10, dans laquelle une longueur verticale de la rainure d'insertion (411) est inférieure à une longueur verticale du corps monté (531).

12. Cuisinière électrique selon l'une quelconque des revendications 4 à 11 lorsqu'elle dépend de la revendication 3, dans laquelle le capteur (700) comporte :
un élément de suspension (720) ayant une forme annulaire et étant suspendu au niveau du corps d'insertion de capteur (520),
un élément de détection (710) qui passe à travers l'élément de suspension (720) et ayant une partie d'extrémité supérieure qui est exposée par l'élément de suspension (720),
un câble électrique (730) électriquement relié à l'élément de détection (710) et s'étendant à travers le corps insertion de capteur (520), et
un connecteur (740) sur une partie d'extrémité du câble électrique (730) et relié au circuit de commande (110a, 110b, 110c), et
dans laquelle la partie d'extrémité supérieure de l'élément de détection (710) est en contact avec la plaque de recouvrement (104).

13. Cuisinière électrique selon la revendication 12, dans laquelle la partie d'extrémité supérieure de l'élément de détection (710) fait saillie à partir de l'élément de suspension (720) et/ou à partir du corps d'insertion de capteur (520).

14. Cuisinière électrique selon la revendication 12 ou 13, dans laquelle le câble électrique (730) est entouré d'une isolation.

15. Cuisinière électrique selon l'une quelconque des revendications 4 à 14 lorsqu'elle dépend de la revendication 3, dans laquelle le corps d'insertion de fusible (510) et/ou le corps d'insertion de capteur (520) font saillie à partir de la base de bobine de travail (410) et/ou à partir de la bobine de travail (420).
